# EUROPEAN PATENT APPLICATION

(11) **EP 4 432 279 A1**
(43) Date of publication of application: **18.09.2024**
(21) Application number: 24163226.4
(22) Date of filing: 13.03.2024
(51) Int. Cl.: G11C 5/02, G11C 5/04, G11C 11/00

(54) **MEMORY PACKAGE EXPANSION**

(30) Priority: 15.03.2023 US 202363452432 P; 11.08.2023 US 202318233296
(71) Applicant: Samsung Electronics Co., Ltd., Suwon-si, Gyeonggi-do 16677 (KR)
(72) Inventor: THIELEN, Casey, San Jose, CA, 95134 (US); JOSEPH, Douglas, San Jose, CA, 95134 (US)
(74) Representative: Kuhnen & Wacker Patent- und Rechtsanwaltsbüro PartG mbB

(57) **Abstract**

A memory solution device may include a logic die, a high-bandwidth memory, and a first memory die. The logic die may be a central processing unit or an accelerator, and may include a first surface. The high-bandwidth memory die may be located on the first surface at a first predetermined location. The first memory die may be located on the first surface at a second predetermined location that is different from the first predetermined location. The first memory die may be a read-only memory, a random access memory, a non-volatile memory, or a combination thereof.

## Description

### TECHNICAL FIELD

The subject matter disclosed herein relates to memory systems for compute nodes. More particularly, the subject matter disclosed herein relates to a compute node die having one or more memory types located at multiple places directly on the compute node die.

### BACKGROUND

Bytes-per-flop as a measurement of memory intensity per compute work has been decreasing for many years as computational advances have significantly outpaced memory bandwidth. Nevertheless, pin bandwidth directly off a processor continues to be a bottleneck to the bytes-per-flop metric. Additionally, a significant amount of power is consumed by a compute node accessing memory that supports a computing node. The power cost increases as memory bandwidth and capacity increases and as physical distance between a compute node to supporting memory increases. The bandwidth that determines the amount of allowable communication between a compute node and the memory is often limited to sub-optimal levels, which relates to pin bandwidth. Increased bandwidth is often desirable to improve bytes-per-flop ratios, although it also increases costs associated with power, particularly if the physical distance is large between the memory and the compute node.

Current memory solutions strive to bring memory closer to a compute node by, for example, using High-Bandwidth Memory (HBM) that is physically located beside a compute node, and static random access memory (SRAM) stacked on top of a compute node.

### SUMMARY

An example embodiment provides a device that may include a logic die, a high-bandwidth memory die and a first memory die. The logic die may include a first surface. The high-bandwidth memory die may be located on the first surface at a first predetermined location, and the first memory die may be located on the first surface at a second predetermined location that is different from the first predetermined location. In one embodiment, the first memory die may include a read-only memory, a random access memory, a non-volatile memory, or a combination thereof. In another embodiment, the first memory die may include at least one of a programmable read-only memory, an erasable programmable read-only memory, and an electrically erasable programmable read-only memory. In still another embodiment, the first memory die may be a random access memory, and a high-bandwidth memory may be stacked on the first memory die. In yet another embodiment, the first memory die may be a dynamic random access memory, a static random access memory, a NAND flash memory, a NOR flash memory, a single or a multi-level phase-change memory, a resistive memory, a nanowire memory, a ferroelectric transistor random access memory, an anti-ferroelectric memory, a domain wall and spin orbit transfer memory, a thyristor-based memory, a spin-transfer torque MRAM, or a combination thereof. In one embodiment, the device may further include a second memory die located on the first surface at a third predetermined location that is different from the first predetermined location and the second predetermined location. In another embodiment, at least one electrical connection between the logic die and at least one of the high-bandwidth memory, the first memory die and the second memory die may be a hybrid copper bond or a microbump bond. In still another embodiment, at least one of the first memory die and the second memory die may be a read-only memory, a random access memory, a non-volatile memory, or a combination thereof. In yet another embodiment, at least one of the first memory die and the second memory die comprises at least one of a programmable read-only memory, an erasable programmable read-only memory, and an electrically erasable programmable read-only memory. In one embodiment, at least one of the first memory die and the second memory die may be at least one of a read-only memory, a random access memory, a programmable read-only memory, an erasable programmable read-only memory, and an electrically erasable programmable read-only memory. In another embodiment, at least one of the first memory die and the second memory die may be a dynamic random access memory, a static random access memory, a NAND flash memory, a NOR flash memory, a single or multi-level phase-change memory, a resistive memory, a nanowire memory, a ferroelectric transistor random access memory, an anti-ferroelectric memory, a domain wall and spin orbit transfer memory, a thyristor-based memory, a spin-transfer torque MRAM, or a combination thereof. In still another embodiment, the logic die may be at least one of a central processing unit (CPU) and an accelerator.

An example embodiment provides a device that may include a logic die, a high-bandwidth memory die, a first memory die and a second memory die. The logic die may include a first surface. The high-bandwidth memory die may be located on the first surface at a first predetermined location. The first memory die may be located on the first surface at a second predetermined location, and at least one electrical connection between the first memory die and the logic die may be a hybrid copper bond or a microbump bond. The second memory die may be located on the first surface at a third predetermined location that is different from the first predetermined location and the second predetermined location, and at least one electrical connection between the second memory die and the logic die may be a hybrid copper bond or a microbump bond. In one embodiment, at least one of the first memory die and the second memory die may be a read-only memory, a random access memory, a non-volatile memory, or a combination thereof. In another embodiment, the first memory die may be a random access memory, and the high-bandwidth memory may be stacked on the first memory die. In still another embodiment, at least one of the first memory die and the second memory die may be a programmable read-only memory, an erasable programmable read-only memory, and an electrically erasable programmable read-only memory. In yet another embodiment, at least one of the first memory die and the second memory die may be a read-only memory, a random access memory, a programmable read-only memory, an erasable programmable read-only memory, and an electrically erasable programmable read-only memory. In one embodiment, at least one of the first memory die and the second memory die may be a dynamic random access memory, a static random access memory, a NAND flash memory, a NOR flash memory, a single or multi-level phase-change memory, a resistive memory, a nanowire memory, a ferroelectric transistor random access memory, an anti-ferroelectric memory, a domain wall and spin orbit transfer memory, a thyristor-based memory, a spin-transfer torque MRAM, or a combination thereof. In another embodiment, the logic die may be at least one of a central processing unit (CPU) and an accelerator.

### BRIEF DESCRIPTION OF THE DRAWING

In the following section, the aspects of the subject matter disclosed herein will be described with reference to exemplary embodiments illustrated in the figure, in which:
FIG. 1A and 1B respectively depict top and side views of an example configuration of multiple memories stacked on a compute die according to the subject matter disclosed herein; and
FIG. 2 depicts an electronic device that may include a compute node die having one or more memory types located at multiple places directly on the compute node die according to the subject matter disclosed herein.

### DETAILED DESCRIPTION

In the following detailed description, numerous specific details are set forth in order to provide a thorough understanding of the disclosure. It will be understood, however, by those skilled in the art that the disclosed aspects may be practiced without these specific details. In other instances, well-known methods, procedures, components and circuits have not been described in detail to not obscure the subject matter disclosed herein.

Reference throughout this specification to "one embodiment" or "an embodiment" means that a particular feature, structure, or characteristic described in connection with the embodiment may be included in at least one embodiment disclosed herein. Thus, the appearances of the phrases "in one embodiment" or "in an embodiment" or "according to one embodiment" (or other phrases having similar import) in various places throughout this specification may not necessarily all be referring to the same embodiment. Furthermore, the particular features, structures or characteristics may be combined in any suitable manner in one or more embodiments. In this regard, as used herein, the word "exemplary" means "serving as an example, instance, or illustration." Any embodiment described herein as "exemplary" is not to be construed as necessarily preferred or advantageous over other embodiments. Additionally, the particular features, structures, or characteristics may be combined in any suitable manner in one or more embodiments. Also, depending on the context of discussion herein, a singular term may include the corresponding plural forms and a plural term may include the corresponding singular form. Similarly, a hyphenated term (e.g., "two-dimensional," "pre-determined," "pixel-specific," etc.) may be occasionally interchangeably used with a corresponding non-hyphenated version (e.g., "two dimensional," "predetermined," "pixel specific," etc.), and a capitalized entry (e.g., "Counter Clock," "Row Select," "PIXOUT," etc.) may be interchangeably used with a corresponding non-capitalized version (e.g., "counter clock," "row select," "pixout," etc.). Such occasional interchangeable uses shall not be considered inconsistent with each other.

Also, depending on the context of discussion herein, a singular term may include the corresponding plural forms and a plural term may include the corresponding singular form. It is further noted that various figures (including component diagrams) shown and discussed herein are for illustrative purpose only, and are not drawn to scale. For example, the dimensions of some of the elements may be exaggerated relative to other elements for clarity. Further, if considered appropriate, reference numerals have been repeated among the figures to indicate corresponding and/or analogous elements.

The terminology used herein is for the purpose of describing some example embodiments only and is not intended to be limiting of the claimed subject matter. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

It will be understood that when an element or layer is referred to as being on, "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numerals refer to like elements throughout. As used herein, the term "and/or" includes any and all combinations of one or more of the associated listed items.

The terms "first," "second," etc., as used herein, are used as labels for nouns that they precede, and do not imply any type of ordering (e.g., spatial, temporal, logical, etc.) unless explicitly defined as such. Furthermore, the same reference numerals may be used across two or more figures to refer to parts, components, blocks, circuits, units, or modules having the same or similar functionality. Such usage is, however, for simplicity of illustration and ease of discussion only; it does not imply that the construction or architectural details of such components or units are the same across all embodiments or such commonly-referenced parts/modules are the only way to implement some of the example embodiments disclosed herein.

Unless otherwise defined, all terms (including technical and scientific terms) used herein have the same meaning as commonly understood by one of ordinary skill in the art to which this subject matter belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

As used herein, the term "module" refers to any combination of software, firmware and/or hardware configured to provide the functionality described herein in connection with a module. For example, software may be embodied as a software package, code and/or instruction set or instructions, and the term "hardware," as used in any implementation described herein, may include, for example, singly or in any combination, an assembly, hardwired circuitry, programmable circuitry, state machine circuitry, and/or firmware that stores instructions executed by programmable circuitry. The modules may, collectively or individually, be embodied as circuitry that forms part of a larger system, for example, but not limited to, an integrated circuit (IC), system on-a-chip (SoC), an assembly, and so forth.

The subject matter disclosed herein provides a high-capacity memory located in a nearest configuration that may be physically available for a compute node. By combining this nearest configuration with additional memory types that may provide other optimizing aspects, the subject matter disclosed herein creates an overall optimized memory hierarchy that reduces cost, power and/or latency for each memory hierarchy, such as main memory versus Last Level Cache (LLC) memory, and optimized for a compute node and applications that are being targeted. More specifically, the configuration disclosed here optimizes power and latency using a stacked configuration.

In one embodiment, the subject matter disclosed herein provides an HBM memory and other additional memory types stacked on top of a compute-system die (or chip). The configuration may be optimized for each memory type used that may be most advantageous for the compute system, including optimization of the distinct levels of memory utilized by the compute system. Overall, stacking memory as disclosed herein improves power, increases bandwidth and decreases latency as compared to existing non-stacked options.

In one embodiment, a memory-optimized solution may target a tiered-memory solution that may be individually optimized for power, latency and/or capacity, all while starting at an optimized power and latency position using a 3D stacking solution. For example, a stacking solution of three or more memory types may provide an advantage of co-located, tiered memory solution that may increase overall capacity for each type of memory while maintaining a nearly ideal position relative to a compute node that accesses each of the memories, regardless of whether a memory is a main memory or a Last-Level Cache (LLC).

Using three-dimensional (3D) stacked-chip technology, the subject matter disclosed herein provides both HBM-based memory as a main memory with one or more additional memory types on top of a compute or logic die. The additional memory types may include, but not limited to, read-only memory (ROM), random access memory (RAM), and non-volatile memory. Each memory type may function in a complementary fashion with other memory types. An HBM may be a main memory that provides an expanded capacity, while SRAM, for example, may function as an LLC cache memory. One advantage that may be provided by this example configuration is that both memory types may be configured with an extremely high bandwidth because the memory types are connected directly to the logic/compute die with very small-pitch electrical connections (hybrid copper bonds or microbump bonds). Both memory types for this example configuration may also be designed to have extremely low latency because both memory types stack directly on top of the logic/compute die.

Such an example configuration may allow memory to be configured for both increased capacity, extremely low latency and may be targeted for separate functionalities, if desired. Power efficiency may be potentially improved through an extremely short distances from compute die to the memories. Example memory types may include SRAM or Dynamic Random Access Memory (DRAM), or other types of memory, which may provide specific benefits according to that memory type, including power efficiency even beyond any efficiency gained from the close proximity of the memory to the compute die.

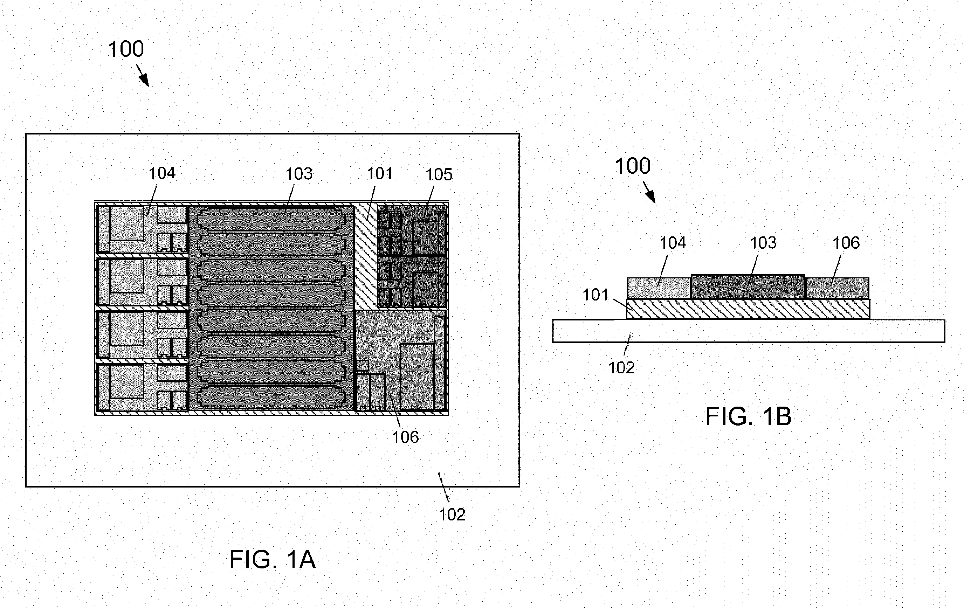

FIG. 1A and 1B respectively depict top and side views of an example configuration 100 of multiple memories stacked on a compute die 101 according to the subject matter disclosed herein. As depicted, the compute die 101 may be disposed on a substrate 102. A first type of memory 103 may be stacked directly on a surface 101a of the compute die 101. The location of the first type memory 103 on the surface 101a of the compute die 101 may be selected to optimize the first type of memory with respect to a location of a function of the compute die 101. The first type memory 103 may be electrically connected to the compute die 101 using small-pitch electrical connections, such as hybrid copper bonds or microbump bonds. In one embodiment, the first type of memory 103 may be, but is not limited to, an HBM. Any number of different memory types may be stacked directly on the surface of the compute die 101. Additionally, micro-cooling channels may be formed between the different types of memory and the compute die 101 to facilitate cooling.

A second type of memory 104, for example, may be stacked directly on the surface 101a of the compute die 101 at a location that has been selected to optimize the second type of memory with respect to a physical location of a system functionality of the compute die 101. The second type memory 104 may be electrically connected to the compute die 101 using small-pitch electrical connections, such as hybrid copper bonds or microbump bonds. The second type of memory may be, for example, a read-only memory, a random access memory, or a non-volatile memory.

A third type of memory 105 may be stacked directly on the surface 101a of the compute die 101 at a location that has been selected to optimize the third type of memory with respect to a physical location of another system functionality of the compute die 101. The third type memory 105 may be electrically connected to the compute die 101 using small-pitch electrical connections, such as hybrid copper bonds or microbump bonds. The third type of memory may be, for example, a read-only memory, a random access memory, or a non-volatile memory.

A fourth type of memory 106 may be stacked directly on the surface 101a of the compute die 101 at a location that has been selected to optimize the third type of memory with respect to a physical location of a system functionality of the compute die 101. The fourth type memory 106 may be electrically connected to the compute die 101 using small-pitch electrical connections, such as hybrid copper bonds or microbump bonds. The fourth type of memory may be, for example, a read-only memory, a random access memory, or a non-volatile memory.

Memory types that may be selected for placement on the surface 101a of the compute die 101 may include, but are not limited to, a high-bandwidth memory, a DRAM, a SRAM, a multi-threshold level NAND flash memory, a NOR flash memory, a single or a multi-level phase-change memory (PCM), a resistive memory (ReRAM), a nanowire memory, a ferroelectric transistor random access memory (FeTRAM), an anti-ferroelectric memory, a domain wall (DW) and spin orbit transfer MRAM (SOT-MRAM) memory, a thyristor-based memory, a spin-transfer torque MRAM (STT-MRAM), or a combination thereof.

An alternative example embodiment may include multiple HBM stacks co-located near each other on the same logic die. This alternate embodiment may allow for an even greater memory capacity expansion for a compute node in an extremely low-latency configuration. Moreover, additional memory pairings may be used, such as discrete DRAM chips stacked next to SRAM chips on the base compute die. Further, DRAM, MRAM, PCM or NAND-based memory pairing may selected to be directly stacked on the surface of a compute die. Any future memory type may be incorporated into the alternative embodiment configuration as long as the future memory remains compatible with assembly methods and use conditions commonly used in microelectronics.

Another example embodiment may provide more than two memory types that are stacked on a compute die, such as, but not limited to, a SRAM chip directly on top of a compute/logic die, and the HBM stack directly on top of the SRAM chip. Advantages provided by this example embodiment may include a significant memory capacity expansion while allowing both to maintain extremely low-latency paths to the logic die at the base. For example, this example configuration may allow a compute node nearly simultaneous access to both a main memory solution and an LLC solution with an extremely low latency for both.

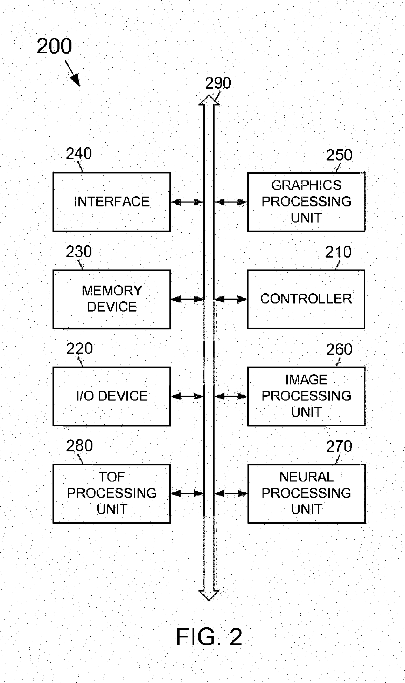

FIG. 2 depicts an electronic device 200 that may include a compute node die having one or more memory types located at multiple places directly on the compute node die according to the subject matter disclosed herein. Electronic device 200 and the various system components of electronic device 200 may be formed from one or more modules. The electronic device 200 may include a controller (or CPU) 210, an input/output (I/O) device 220 such as, but not limited to, a keypad, a keyboard, a display, a touch-screen display, a 2D image sensor, a 3D image sensor, a memory 230, an interface 240, a GPU 250, an imaging-processing unit 260, a neural processing unit 270, a TOF processing unit 280 that are coupled to each other through a bus 290. In one embodiment, the controller (CPU) 210 may be configured as a compute node and the memory 230 may be configured as multiple memory types in which each memory type may be located directly on the surface of the die of the controller 210 according to the subject matter disclosed herein. In another embodiment, the controller 210 may be configured to include one or more logic blocks and functionalities that would involve different memory types that may be configured as a silicon structure. That is, the controller 210 may configured to be a logic die that includes various types of computer and/or I/O and/or memory and/or network blocks that are formed as a silicon structure. In one embodiment, the 2D image sensor and/or the 3D image sensor may be part of the imaging processing unit 260. In another embodiment, the 3D image sensor may be part of the TOF processing unit 280. In one embodiment, the controller 210 may include, for example, at least one microprocessor, at least one digital signal processor, at least one microcontroller, or the like. The memory 230 may be configured to store command codes that are to be used by the controller 210 and/or to store a user data.

The interface 240 may be configured to include a wireless interface that is configured to transmit data to or receive data from, for example, a wireless communication network using a RF signal. The wireless interface 240 may include, for example, an antenna. The electronic system 200 also may be used in a communication interface protocol of a communication system, such as, but not limited to, Code Division Multiple Access (CDMA), Global System for Mobile Communications (GSM), North American Digital Communications (NADC), Extended Time Division Multiple Access (E-TDMA), Wideband CDMA (WCDMA), CDMA2000, Wi-Fi, Municipal Wi-Fi (Muni Wi-Fi), Bluetooth, Digital Enhanced Cordless Telecommunications (DECT), Wireless Universal Serial Bus (Wireless USB), Fast low-latency access with seamless handoff Orthogonal Frequency Division Multiplexing (Flash-OFDM), IEEE 802.20, General Packet Radio Service (GPRS), iBurst, Wireless Broadband (WiBro), WiMAX, WiMAX-Advanced, Universal Mobile Telecommunication Service - Time Division Duplex (UMTS-TDD), High Speed Packet Access (HSPA), Evolution Data Optimized (EVDO), Long Term Evolution - Advanced (LTE-Advanced), Multichannel Multipoint Distribution Service (MMDS), Fifth-Generation Wireless (5G), Sixth-Generation Wireless (6G), and so forth.

Embodiments of the subject matter and the operations described in this specification may be implemented in digital electronic circuitry, or in computer software, firmware, or hardware, including the structures disclosed in this specification and their structural equivalents, or in combinations of one or more of them. Embodiments of the subject matter described in this specification may be implemented as one or more computer programs, i.e., one or more modules of computer-program instructions, encoded on computer-storage medium for execution by, or to control the operation of data-processing apparatus. Alternatively or additionally, the program instructions can be encoded on an artificially-generated propagated signal, e.g., a machine-generated electrical, optical, or electromagnetic signal, which is generated to encode information for transmission to suitable receiver apparatus for execution by a data processing apparatus. A computer-storage medium can be, or be included in, a computer-readable storage device, a computer-readable storage substrate, a random or serial-access memory array or device, or a combination thereof. Moreover, while a computer-storage medium is not a propagated signal, a computer-storage medium may be a source or destination of computer-program instructions encoded in an artificially-generated propagated signal. The computer-storage medium can also be, or be included in, one or more separate physical components or media (e.g., multiple CDs, disks, or other storage devices). Additionally, the operations described in this specification may be implemented as operations performed by a data-processing apparatus on data stored on one or more computer-readable storage devices or received from other sources.

While this specification may contain many specific implementation details, the implementation details should not be construed as limitations on the scope of any claimed subject matter, but rather be construed as descriptions of features specific to particular embodiments. Certain features that are described in this specification in the context of separate embodiments may also be implemented in combination in a single embodiment. Conversely, various features that are described in the context of a single embodiment may also be implemented in multiple embodiments separately or in any suitable subcombination. Moreover, although features may be described above as acting in certain combinations and even initially claimed as such, one or more features from a claimed combination may in some cases be excised from the combination, and the claimed combination may be directed to a subcombination or variation of a subcombination.

Similarly, while operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system components in the embodiments described above should not be understood as requiring such separation in all embodiments, and it should be understood that the described program components and systems can generally be integrated together in a single software product or packaged into multiple software products.

Thus, particular embodiments of the subject matter have been described herein. Other embodiments are within the scope of the following claims. In some cases, the actions set forth in the claims may be performed in a different order and still achieve desirable results. Additionally, the processes depicted in the accompanying figures do not necessarily require the particular order shown, or sequential order, to achieve desirable results. In certain implementations, multitasking and parallel processing may be advantageous.

As will be recognized by those skilled in the art, the innovative concepts described herein may be modified and varied over a wide range of applications. Accordingly, the scope of claimed subject matter should not be limited to any of the specific exemplary teachings discussed above, but is instead defined by the following claims.

## Claims

1. A device, comprising:
a logic die comprising a first surface;
a high-bandwidth memory die located on the first surface at a first predetermined location; and
a first memory die located on the first surface at a second predetermined location.

2. The device of claim 1, wherein the first memory die comprises a read-only memory, ROM, a random access memory, RAM, a non-volatile memory, or a combination thereof.

3. The device of claim 2, wherein the first memory die comprises at least one of a programmable read-only memory, PROM, an erasable programmable read-only memory, EPROM, and an electrically erasable programmable read-only memory, EEPROM.

4. The device of claim 1, wherein the first memory die comprises a random access memory, RAM, and
wherein a high-bandwidth memory is stacked on the first memory die.

5. The device of claim 1, wherein the first memory die comprises a dynamic random access memory, DRAM, a static random access memory, SRAM, a NAND flash memory, a NOR flash memory, a single or a multi-level phase-change memory, PCM, a resistive memory, ReRAM, a nanowire memory, a ferroelectric transistor random access memory, FeTRAM, an anti-ferroelectric memory, a domain wall, DW, and spin orbit transfer, SOT, memory, a thyristor-based memory, a spin-transfer torque MRAM, STT-MRAM, or a combination thereof.

6. The device of claim 1, further comprising a second memory die located on the first surface at a third predetermined location that is different from the first predetermined location and the second predetermined location.

7. The device of claim 6, wherein at least one electrical connection between the logic die and at least one of the high-bandwidth memory, the first memory die and the second memory die comprises a hybrid copper bond or a microbump bond.

8. The device of claim 6 or 7, wherein at least one of the first memory die and the second memory die comprises a read-only memory, ROM, a random access memory, RAM, a non-volatile memory, or a combination thereof.

9. The device of any one ofclaims 6 to 8, wherein at least one of the first memory die and the second memory die comprises at least one of a programmable read-only memory, PROM, an erasable programmable read-only memory, EPROM, and an electrically erasable programmable read-only memory, EEPROM.

10. The device of claim 6 or 7, wherein at least one of the first memory die and the second memory die comprises at least one of a read-only memory, ROM, a random access memory, RAM, a programmable read-only memory, PROM, an erasable programmable read-only memory, EPROM, and an electrically erasable programmable read-only memory, EEPROM.

11. The device of claim 6 or 7, wherein at least one of the first memory die and the second memory die comprises a dynamic random access memory, DRAM, a static random access memory, SRAM, a NAND flash memory, a NOR flash memory, a single or multi-level phase-change memory, PCM, a resistive memory, ReRAM, a nanowire memory, a ferroelectric transistor random access memory, FeTRAM, an anti-ferroelectric memory, a domain wall, DW and spin orbit transfer, SOT memory, a thyristor-based memory, a spin-transfer torque MRAM, STT-MRAM, or a combination thereof.

12. The device of any one of claims 1 to 11, wherein the logic die comprises at least one of a central processing unit, CPU, and an accelerator.

13. The device of any one of claims 1 to 12, wherein the second predetermined location is different from the first predetermined location.

14. The device according to any one of claims 6 to 12, wherein:
at least one electrical connection between the first memory die and the logic die comprises a hybrid copper bond or a microbump bond; and
at least one electrical connection between the second memory die and the logic die comprises a hybrid copper bond or a microbump bond.

15. The device of claim 14, wherein the first memory die comprises a random access memory, RAM, and
a high-bandwidth memory is stacked on the first memory die.
